# EUROPÄISCHE PATENTSCHRIFT

(11) **EP 1 864 146 B1**
(45) Veröffentlichungstag und Bekanntmachung des Hinweises auf die Patenterteilung: **12.03.2014**
(21) Anmeldenummer: 05821936.1
(22) Anmeldetag: 24.11.2005
(51) Int. Cl.: G01R 31/308, G01R 31/309

(54) **INSPEKTIONSVORRICHTUNG**
INSPECTION DEVICE
DISPOSITIF D'INSPECTION

(30) Priorität: 24.11.2004 DE 102004056698
(43) Veröffentlichungstag der Anmeldung: 12.12.2007
(73) Patentinhaber: Stratus Vision GmbH, 82116 Gräfelfing (DE)
(72) Erfinder: STENGER, Heinrich, 82166 Gräfelfing (DE)
(74) Vertreter: Baronetzky, Klaus
(86) Internationale Anmeldenummer: PCT/EP2005/012596
(87) Internationale Veröffentlichungsnummer: WO 2006/056453

(56) Entgegenhaltungen:
- EP-A- 0 443 289
- US-A- 4 673 988
- US-A1- 2001 055 417
- US-B1- 6 201 892

## Beschreibung

Die Erfindung betrifft eine Inspektionsvorrichtung, gemäß dem Oberbegriff von Anspruch 1.

Eine derartige Inspektionsvorrichtung wird eingesetzt, um die Qualität von insbesondere in Dickschichttechnik aufgebrachten Schaltkreisen zu prüfen. Derartige Schaltkreise werden regelmäßig in einer Vielzahl, beispielsweise 20, von Schichten mittels Siebdrucktechnik aufgebracht. Hierbei ist es wichtig, dass nicht beispielsweise aufgrund von Maskenfehlern fehlerhafte Schichten aufgebracht werden.

Um dies zu prüfen, ist es bekannt geworden, mittels elektrischer Testausrüstung die Funktion der Schaltkreise im Einzelnen zu testen. Nachteilig hierbei ist es, dass meist alle Schichten aufgebracht werden müssen und dann die Prüfung vorgenommen werden kann. Wenn der Test Fehler ergeben hat, besteht lediglich die Möglichkeit, den betreffenden Chip zu verwerfen, mit den entsprechenden Kostennachteilen.

Ferner ist es auch bereits vorgeschlagen worden, während des Aufbringens der Schichten optische Prüfungen vorzunehmen. Diese können beispielsweise visuell, also über einen geschulten Bediener erfolgen. Es ist aber auch bekannt geworden, über geeignete optische Erfassungsvorrichtungen das Bild der gedruckten Schicht oder Schichten zu erfassen und mit einem Sollbild zu vergleichen. Wenn die Abweichung dann zu groß ist, wird der betreffende Chip ausgesondert.

Es sind zahlreiche Lösungen bekannt geworden, in welcher weise derartige Inspektionsvorrichtungen realisiert und verbessert werden können. Ein Beispiel hierfür ist die US-PS 4,389,669. Bei dieser Lösung wird mit einer optischen Erfassungsvorrichtung, nämlich einem Mikroskop, unter Verwendung einer Kamera eine optische Prüfung vorgenommen, die dem Grunde nach auch für die Erfassung von Chips geeignet ist. Allerdings erfordert die dortige Lösung bei der Kundenforderung einer raschen und zuverlässigen Prüfung der elektronische Schaltkreise oder Chips einen erheblichen gerätetechnischen Aufwand.

US20010055417 offenbart eine Vorrichtung mit der Einzelbilder aufgenommen und zusammengefügt werden.

US6201892 offenbart eine Vorrichtung bei der Bilder bei Bewegung einer Bewegungsvorrichtung aufgenommen werden wozu Lichtimpulse erzeugt werden.

Ein weiteres Beispiel für die Erfassung von elektronischen Schaltkreise mittels Kameras ist aus der US-PS 5,245,421 ersichtlich, wobei gemäß der US-PS 5,060,065 auch spezielle Beleuchtungsvorrichtungen eingesetzt werden können, um die Möglichkeiten der Erfassung zu verbessern.

Aus der US-PS 4,673,988 ist es schließlich bereits bekannt, eine Inspektionsvorrichtung unter Verwendung eines in Bildbereiche aufgeteilten Bildes zu realisieren. Dies geschieht über den dort vorgesehenen Bildprozessor, wobei das zu inspizierende Objekt in zwei Dimensionen bewegbar ist.

Den genannten Lösungen haftet der gemeinsame Nachteil an, dass ein vergleichsweise großer gerätetechnischer Aufwand erforderlich ist, aber dennoch die Auswertungsgeschwindigkeit zu wünschen übrig lässt, gerade wenn eine Vielzahl von Schichten eines Chips geprüft werden sollen. Zudem ist die Erfassungsgenauigkeit der bekannten Lösungen verbesserungswürdig, gerade dann, wenn eine Inspektionsvorrichtung für einen raschen Durchsatz mit einer geringen Auflösung konzipiert wurde, aber eine genauere Erfassung bei einer bestimmten Serie der Chips vorgenommen werden soll.

Daher liegt der Erfindung die Aufgabe zu Grunde, eine Inspektionsvorrichtung gemäß dem Oberbegriff von Anspruch 1 zu schaffen, die hinsichtlich des Durchsatzes, aber auch der Erfassungsgenauigkeit und -zuverlässigkeit weiter verbessert ist, wobei auch eine flexible Anpassung an unterschiedliche Anforderungen möglich sein soll.

Diese Aufgabe wird erfindungsgemäß durch Anspruch 1 gelöst. Vorteilhafte Weiterbildungen ergeben sich aus den Unteransprüchen.

Die erfindungsgemäße Lösung zeichnet sich durch eine besonders flexible und damit gut an unterschiedliche Erfordernisse anpassbare, aber dennoch zuverlässige Inspektionsmöglichkeit für Chips oder dergleichen aus. Durch die besondere Beleuchtungsvorrichtung mit einer Vielzahl von Leuchtelementen, die sich beispielsweise auch, in mehreren Farben gruppiert, um einen Tunnel herum anordnen, ist sichergestellt, dass eine intensive Beleuchtung zentral an der durch die Erfassungsvorrichtung betrachtete Stellung erfolgt, und zwar je nach Art der aufgebrachten Schicht. Hierdurch ist es nicht erforderlich, die bereits vorgeschlagene Schrägbeleuchtung mit ihren Nachteilen vorzusehen, und zwar auch dann nicht, wenn die Schichten reflektierend sind.

Gemäß einer modifizierten Ausführungsform entfällt der Tunnel, und die Beleuchtung wird durch eine an geeigneter Stelle gruppierte Beleuchtungsvorrichtung sichergestellt. Besonders günstig ist es jedenfalls, dass das Bild gestrobt werden kann, dass also die Belichtung der Digitalkamera durch die Steuerung der Beleuchtungsvorrichtung erfolgt, während der Verschluss der Digitalkamera während des Betriebs offen bleiben kann.

Die Reflektionen werden durch die allseits leicht schräg angeordneten Leuchtdioden, die symmetrisch das Licht der Erfassungsvorrichtung zuleiten, praktisch in ihrer Wirkung so abgeschwächt, dass die Erkennungsrate überraschend gut ist. Überraschend zeigt es sich, dass sich besonders gute Ergebnisse in Verbindung mit dem CCD-Sensor einen Digitalkamera erzielen lassen: Offenbar sind die in Digitalkameras verwendeten CCD-Elemente trotz geringerer Auflösung empfindlicher und damit selektiver, was die Erfassung von Fehlern in einem Raster angeht. In besonders günstiger Ausgestaltung der Erfindung wird nämlich dann ein Fehler angenommen, wenn drei einander benachbarte Pixel einen gegenüber dem Referenzbild abweichenden Wert anzeigen.

Besonders günstig ist es ferner, wenn durch die intensive Ausleuchtung, die aber dennoch eine leichte, aber nicht zu große Schrägstellung umfasst, auch bei hohen Auflösungen mit kurzer Belichtungszeit gearbeitet werden kann, so dass die Taktzeit für die Erfassung verbessert ist.

In einer erfindungsgemäßen besonders günstigen Ausgestaltung wird das erfasste Bild einem Framegrabber zugeleitet, der es an eine PC weiterleitet, und erst dort erfolgt dann mit einem geringen Zeitversatz die Fehlererkennung.

Durch diese Art Pipelining und Verteilung von Aufgaben lässt sich mit vergleichsweise preisgünstiger Technik ein guter Durchsatz erzielen, so dass es beispielsweise nicht erforderlich ist, den PC in Echtzeit zu betreiben.

Typischerweise werden aus Kostengründen eine Vielzahl von einander gleichen elektronischen Schaltungen auf einem gemeinsamen Substrat, zum Beispiel einem Wafer oder einem Kerämiksubstrat, gefertigt. Beispielsweise können Keramiksubstrate auch Größen von 20 x 20 cm haben. Auf einem derartigen Substrat befinden sich dann beispielsweise 50 oder sogar 200 entsprechende elektronische Schaltkreise. Typischerweise ist nun die Größe (Länge x Breite) eines Schaltkreises unabhängig von der Aufnahme des Einzelbildes durch die erfindungsgemäße Digitalkamera. Erfindungsgemäß ist nun die Möglichkeit vorgesehen, mehrere Einzelbilder durch elektronische Aufbereitung passgenau zu einem Gesamtbild zusammenzufügen, so dass die Fehlererkennung wesentlich rascher erfolgen kann, als wenn für jede Überprüfung die Digitalkamera genau auf einen elektronischen Schaltkreis fokussiert werden müsste. Die Geschwindigkeit ist damit im Grunde unabhängig von der Größe der Schaltkreise und lediglich von der gewünschten Auflösung und der Substratlösung abhängig, was einen erheblichen Fortschritt gegenüber der bekannten Lösungen bedeutet.

In vorteilhafter Ausgestaltung werden die Einzelbilder im Flug aufgenommen, also während der Relativbewegung zwischen Digitalkamera und Substrat beziehungsweise dessen Führungsunterlage. Dies ist lediglich dann möglich, wenn die Belichtungszeit im Verhältnis zur Relativbewegung kurz ist, so dass hierdurch keine Unschärfen entstehen. Diese Lösung hat den Vorteil, dass kein "Nachzittern" beim Abbremsen des Linearantriebs eine Unschärfe auslösen kann, und dass der Antrieb weniger belastet wird und damit länger lebig ist.

Diese Lösung bedingt eine intensive Ausleuchtung, um eine kurze Belichtungszeit zu erhalten.

Gemäß einer alternativen Ausgestaltung ist es ohne weiteres möglich, die Bewegungsvorrichtung für jedes Einzelbild anzuhalten und dann das betreffende Einzelbild anzufertigen. Hierdurch sind geringere Anforderungen an die Belichtung und die Digitalkamera gegeben.

In einer weiteren besonders günstigen Ausgestaltung ist es vorgesehen, die Grundauflösung der Digitalkamera unabhängig von der zu erfassenden Auflösung beizubehalten. Die Anpassung kann entweder durch ein elektronisches Zoom oder bevorzugt durch ein echtes optisches Zoom in der Optik realisiert werden, so dass sich bei einer größeren Fehlertoleranz, also einer geringeren Pixelauflösung für die Fehler eine raschere Zykluszeit erzielen lässt.

Besonders günstig ist es, dass die Farbe beziehungsweise das emittierte Lichtspektrum der Einzel-Leuchtelemente an den Anwendungsfall ohne weiteres angepasst werden kann. Bevorzugt gehören zu den Leuchtelementen auch UV-Leuchtdioden oder -Laserdioden, die eine besonders günstige Kontrastwirkung für Goldschichten ermöglichen. Erfindungsgemäß besonders bevorzugt ist es auch, die Pulsbreite an die verwendeten Schichtmaterialen anzupassen und so eine Optimierung der Fehlererkennung vorzunehmen.

Besonders günstig ist es, dass die Inspektionsvorrichtung bei einer Auflösung von 10 Mikrometern auf dem Substrat ein Einzelbild von 30 x 30 mm in weniger als 10 Sekunden, insbesondere näherungsweise 4 Sekunden, inspiziert.

Es versteht sich, dass der erfindungsgemäße Tunnel nicht unbedingt konisch aufgeweitet sein muss. Ein zylindrischer Tunnel, an dessen Innenumfang die Leuchtelemente befestigt sind, ermöglicht es vielmehr, mit noch geringeren Abschattungen zu arbeiten.

Außerdem ist der Schrägstellungswinkel der von dem Substrat fern angeordneten Leuchtelemente größer, was in verschiedenen Anwendungsfällen günstig ist.

Erfindungsgemäß ist eine Inspektionsvorrichtung mit einem Inspektionskopf vorgesehen, der relativ zu einer Führungsunterlage in mindestens zwei Richtungen beweglich ist, welche Führungsunterlage ein zu inspizierendes Substrat lagert, wobei das Substrat mindestens eine aufgebrachte, insbesondere aufgedruckte, Schicht aufweist. Der Inspektionsköpf weist eine Beleuchtungsvorrichtung und eine Erfassungsvorrichtung auf, die von dem Substrat reflektierte oder durch es hindurchgelassene elektromagnetische Strahlung erfasst und einer Auswertvorrichtung zuleitet, mit welcher Abweichungen des Substrats, z. B. Fehler des Substrats, von einem vorgegebenen Substrat oder Übereinstimmungen mit einem vorgegebenen Substrat erfassbar sind. Die Erfassungsvorrichtung weist eine Digitalkamera mit einer Optik auf, die eine Auflösung von weniger als 200, insbesondere weniger als 30, Mikrometern auf dem Substrat erfasst, und die Bewegungsvorrichtung steuert die Relativbewegung zwischen Führungsunterlage und Inspektionskopf während eines Aufnahmezyklus steuert, bei dem aneinander anschließende oder überlappende Einzelbilder zu einem Gesamtbild des Substrats zusammenfügbar sind.

Das vorgebenene Substrat kann ein fehlerfreies Muster sein. Es können aber auch Daten, z.B. im sogenannten Gerber-Format vorliegende Daten eines gedruckten Schaltkreises, genutzt werden.

In einer weiteren vorteilhaften Ausgestaltungen ist es vorgesehen, dass der Inspektionskopf einen Tunnel aufweist, der insbesondere Leuchtelemente der Beleuchtungsvorrichtung für die Beleuchtung des Substrats trägt.

In einer weiteren vorteilhaften Ausgestaltungen ist es vorgesehen, dass die Bilder im Flug aufnehmbar sind und die Bewegungsvorrichtung so gesteuert ist, dass aneinander anschließende oder leicht überlappende Einzelbilder bei gleichförmiger Bewegung der Bewegungsvorrichtung erfassbar sind.

In einer weiteren vorteilhaften Ausgestaltungen ist es vorgesehen, dass die zu erfassende Fehlergröße durch Verstellung der Optik und/oder der Aufnahmeauflösung der Digitalkamera vom Anwender der Inspektionsvorrichtung einstellbar ist und bei gröberer Fehlergröße die Bildgröße jedes Einzelbildes vergrößerbar ist oder sein kann.

In einer weiteren vorteilhaften Ausgestaltungen ist es vorgesehen, dass die Beleuchtungsvorrichtung eine Durchlichteinheit aufweist, die unter der Führungsunterlage angebracht ist sich gegebenenfalls mit dieser fortbewegt und mit welcher durchscheinende Substrate inspizierbar sind und dass insbesondere unterhalb der Führungsunterlage eine LED-Bett vorgesehen ist.

In einer weiteren vorteilhaften Ausgestaltungen ist es vorgesehen, dass Substrate als Keramiksubstrate, Keramikfibritsubstrate, Metall, LTCC-Substrate und/oder glasfaserverstärkte Epoxidharzsubstrate ausgebildet sind, die in Mehrschichttechnik (Multilayer) im Siebdruck bedruckbar sind.

In einer weiteren vorteilhaften Ausgestaltungen ist es vorgesehen, dass die Inspektionsvorrichtung Teil einer Erzeugungsanlage für bedruckte Substrate ist, in welcher die teilweise bedruckten Substrate der Inspektionsvorrichtung nach Drucken mindestens einer Sicht zuführbar, dann wieder bedruckbar und dann erneut der Inspektionsvorrichtung zyklisch zuführbar ist, bis sämtliche Schichten inspiziert sind.

In einer weiteren vorteilhaften Ausgestaltungen ist es vorgesehen, dass nach der Inspektion durch die Inspektionsvorrichtung jede Schicht zyklisch in einem Trockenofen oder Brennofen einbrennbar ist.

In einer weiteren vorteilhaften Ausgestaltungen ist es vorgesehen, dass in Anpassung an die verschiedenen Materialien der Schichten die Farbe der Beleuchtungsvorrichtung einstellbar ist, wobei die Beleuchtungsvorrichtung insbesondere eine Vielzahl von LEDs oder Laserdioden aufweist.

In einer weiteren vorteilhaften Ausgestaltungen ist es vorgesehen, dass die Beleuchtungsvorrichtung einen Lichtleiter, insbesondere ein Glasfaserkabel, aufweist und dass zwischen der Beleuchtungsvorrichtung und dem Substrat mindestens eine Linse zur Erhöhung der Leuchtdichte angeordnet ist.

In einer weiteren vorteilhaften Ausgestaltungen ist es vorgesehen, dass die Beleuchtungsvorrichtung eine Taktsteuerung aufweist, mit welcher die einzelnen Leuchtelemente der Beleuchtungsvorrichtung im Impulsbetrieb ansteuerbar sind.

In einer weiteren vorteilhaften Ausgestaltungen ist es vorgesehen, dass die Beleuchtungsvorrichtung einen Lichtimpuls zur Ausleuchtung der betreffenden Aufnahme der Digitalkamera auflöst, der mit der Aufnahmesteuerung der Digitalkamera synchronisiert ist.

In einer weiteren vorteilhaften Ausgestaltungen ist es vorgesehen, dass eine Digitalkamera zur Erfassung des Bildes des Substrats vorgesehen ist, deren Verschluss offen ist und dass die digitale Belichtung durch die Steuerung der Beleuchtungsvorrichtung erfolgt.

In einer weiteren vorteilhaften Ausgestaltungen ist es vorgesehen, dass die Leuchtelemente der Beleuchtungsvorrichtung in einem sich in einem Winkel von 0° bis 50°, insbesondere etwa 20° konisch aufweitenden Tunnel angeordnet sind und insbesondere mindestens teilweise dem Substrat zugewandt sind.

In einer weiteren vorteilhaften Ausgestaltungen ist es vorgesehen, dass an die Digitalkamera ein Framegrabber angeschlossen ist, dessen Ausgang mit einem PC verbunden ist, der die Fehlererkennung vornimmt.

In einer weiteren vorteilhaften Ausgestaltungen ist es vorgesehen, dass mindestens zwei aufgedruckte Schichten auf dem Substrat vorgesehen sind, die sich insbesondere mindestens teilweise überlappend und nacheinander aufgebracht sind.

In einer weiteren vorteilhaften Ausgestaltungen ist es vorgesehen, dass der Tunnel sich zum Substrat mindestens teilweise aufweitet, insbesondere konisch aufweit und dass an dem Innenumfang des Tunnels eine Vielzahl von Leuchtelementen angebracht sind.

In einer modifizierten Ausführungsform ist es erfindungsgemäß vorgesehen, dass das Substrat mindestens eine Schicht mit Ausnehmungen, Erhebungen oder Vertiefungen ausweist. Der Inspektionskopf weist eine Beleuchtungsvorrichtung und eine Erfassungsvorrichtung auf, die von dem Substrat reflektierte oder hindurchgelassene elektromagnetische Strahlung erfasst.

In einer weiteren modifizierten Ausführungsform ist es erfindungsgemäß vorgesehen, dass die Erfassungsvorrichtung eine Digitalkamera mit einer Optik aufweist, die eine Auflösung von weniger als 200, insbesondere weniger als 30, Mikrometern auf dem Substrat erfasst, und dass die Bewegungsvorrichtung die Relativbewegung zwischen Führungsunterlage und Inspektionskopf während eines Aufnahmezyklus steuert, bei dem aneinander anschließende oder einander überlappende Einzelbilder oder Einzelbilder, die voneinander beabstandet sind, zu einem Gesamtbild des Substrats zusammenfügbar sind.

Weitere Vorteile, Einzelheiten und Merkmale ergeben sich aus der nachfolgenden Beschreibung zweier Ausführungsbeispiele der Erfindung anhand der Zeichnung.

Es zeigen:
- Fig. 1: eine erfindungsgemäße Inspektionsvorrichtung in einer Ausführungsform, und
- Fig. 2: eine modifizierte Ausführungsform eines Teils einer erfindungsgemäßen Inspektionsvorrichtung.

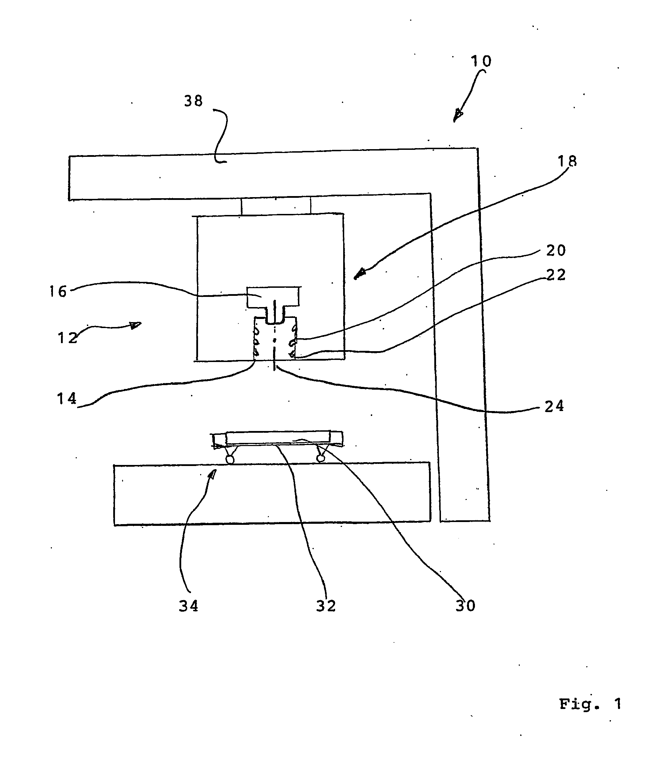

Die in Fig. 1 dargestellte Inspektionsvorrichtung 10 weist einen Inspektionskopf 12 auf, der seinerseits eine Beleuchtungsvorrichtung 14 und eine Erfassungsvorrichtung 16 aufweist.

Die Erfassungsvorrichtung 16 weist eine Digitalkamera 18 sowie gegebenenfalls eine zugehörige und nicht dargestellte Optik auf. Sie ist mit einer nicht dargestellten Auswertvorrichtung verbunden, die die Bilddaten nach Umwandlung in elektrische Signale aufbereitet und auswertet. Hierzu ist ein Framegrabber sowie ein PC angeschlossen, wobei der PC die einstellbare Fehlerauswertung vornimmt.

Die Beleuchtungsvorrichtung 14 besteht aus einer Vielzahl von bevorzugt leicht schräg gelagerten Leuchtdioden 20, 22, die in einem Tunnel 24 angeordnet sind. In dem dargestellten Ausführungsbeispiel ist der Tunnel zylindrisch ausgebildet und die Leuchtdioden 20, 22 sind an seinem Innenumfang an verschiedenen Reihen beziehungsweise Ringen angeordnet. Leuchtdioden verschiedener Farbe werden für die unterschiedlichen zu erfassenden Materialien eingesetzt.

Eine optische Achse 28 verläuft zentral durch den Tunnel 24 und trifft unten auf ein Substrat 30. Das Substrat 30 ist auf eine Führungsunterlage 32 gelagert. Die Führungsunterlage 32 ist in dem dargestellten Ausführungsbeispiel senkrecht zur Zeichnungsebene verfahrbar. Insgesamt ist die Führungsunterlage 32 relativ zu dem Inspektionskopf 12 in zwei Dimensionen über die Bewegungsvorrichtung 34 verfahrbar, wobei in dem dargestellten Ausführungsbeispiel hierzu der Inspektionskopf 12 gegenüber einem Rahmen 38 nach rechts und links verfahrbar ist. Es versteht sich, dass in beliebiger anderer Weise die erwünschte Bewegungsmöglichkeit des Substrats 30 gegenüber Inspektionskopf 12 realisierbar ist.

Der Inspektionskopf wird nun über Linearmotoren oder dergleichen der Bewegungsvorrichtung relativ zum Substrat 30 gleichmäßig bewegt, und es werden Einzelbilder aufgenommen. Die Einzelbilder werden dem Framegrabber über die Digitalkamera 18 zugeleitet, der die Datenaufbereitung vornimmt. Im angeschlossenen PC wird das gewünschte Gesamtbild zusammengefügt und erfasst.

Es versteht sich, dass anstelle der Erfassung und Auswertung des Gesamtbildes des Substrats auch Einzelbilder hinsichtlich der Fehler auswertbar sind, wobei jedoch erfindungsgemäß die Möglichkeit besteht, die Einzelbilder zu einem Gesamtbild zusammenzufügen.

Als Substrate können beliebige geeignete Substrate für elektronische Schaltkreise eingesetzt werden, beispielsweise aus Keramik, Keramikfibrit, Metall oder LTCC. Es sind auch glasfaserverstärkte Epoxidharzsubstrate prüfbar oder beliebig andere geeignete Substrate.

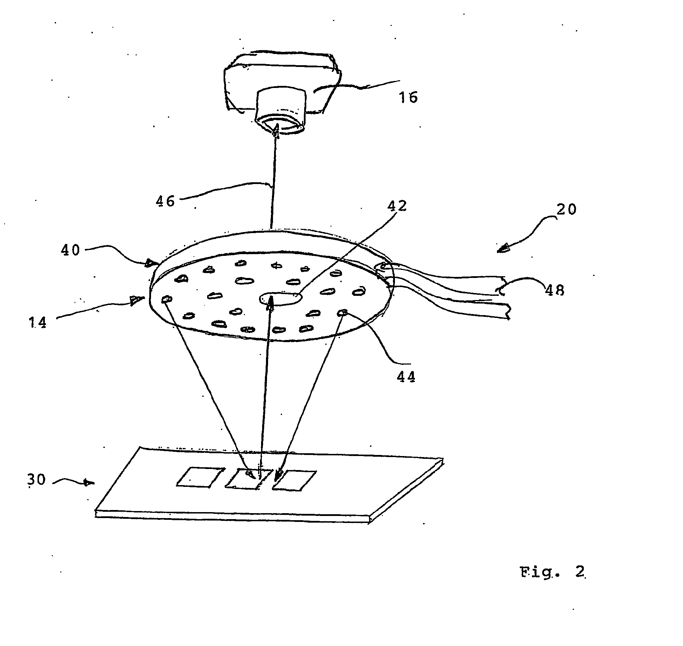

Die in Fig. 2 dargestellte Inspektionsvorrichtung 10 unterscheidet sich von der Inspektionsvorrichtung gemäß Fig. 1 durch eine andere Beleuchtungsvorrichtung 14. Es ist eine Art Schreibe 40 vorgesehen, die eine zentrale Öffnung 42 aufweist und an ihrer Unterseite eine Vielzahl von Lichtquellen beziehungsweise Leuchtelementen 44 trägt. Die Leuchtelemente 44 beaufschlagen das Substrat mit der gewünschten Belichtung. Das reflektierte Licht 46 wird durch die Öffnung 42 der Digitalkamera 16 zugeleitet.

Bei dieser Lösung erfolgt die Belichtung über die Leuchtelemente 44 gestrobt, also bei offenem Verschluss der Digitalkamera. Es können auch zahlreiche verschiedenfarbige Leuchtelemente 44 vorgesehen sein, die je nach Bedarf über die dort vorgesehenen Kabel 48 angesteuert werden. Die Kabel 48 können Glasfaserkabel sein, die den Leuchtelementen 44 Licht in an sich bekannter Form zuleiten, wobei die eigentliche Lichtquelle dann entfernt an geeigneter Stelle angeordnet sein kann. Alternativ können die Kabel 48 auch elektrische Anschlusskabel für Leuchtdioden sein, die dann an den aus Fig. 2 ersichtlichen Stellen angebracht sind. Besonders günstig ist es, dass die Inspektion mit dem erfindungsgemäßen Stroben, also der Steuerung der Belichtung über die Leuchtelemente 44 in einem Zug oder on the fly erfolgen kann. Dies ist auch besonders für die Realisierung von hohen Auflösungen günstig.

Anstelle des Tunnels 24 kann auch eine beliebige andere Anordnung der Leuchtdioden 20, 22 vorgesehen sein. Beispielsweise können sie in der Form eines Pyramidenstumpfs angeordnet sein oder beispielsweise in vier voneinander divergierenden und zum Substrat hin sich erstreckenden Reihen.

## Patentansprüche

1. Inspektionsvorrichtung, mit
- einer Führungsunterlage (32), *auf der ein zu inspizierendes Substrat, welches aufgebrachte Schichten aufweist, lagerbar ist,* und
- einem Inspektionskopf (12), der relativ zu *dieser* Führungsunterlage (32) in mindestens zwei Richtungen beweglich ist,
- wobei der Inspektionskopf (12)
eine Beleuchtungsvorrichtung (14), und
eine Erfassungsvorrichtung (16) aufweist,
- einer Auswertvorrichtung und
- einer Bewegungsvorrichtung (34), welche ausgelegt ist, die Führungsuntertage (32) relativ zum Inspektionskopf (12) zu bewegen und diese Bewegung zu steuern,
- wobei die Erfassungsvorrichtung (16) von dem Substrat reflektierte oder durch es hindurchgelassene elektromagnetische Strahlung erfasst und der Auswertvorrichtung zuleitet, und eine Digitalkamera (18) mit einer Optik aufweist, die ausgefegt ist, eine Auflösung von weniger als 200, insbesondere weniger als 30, Mikrometern auf dem Substrat (30) zu erfassen, und
**dadurch gekennzeichnet, dass**
- die Inspektionsvorrichtung dafür angepasst ist aneinander anschließende oder leicht überlappende Einzelbilder bei gleichförmiger Bewegung der Bewegungsvorrichtung zu erfassen, und
- wobei die Beleuchtungsvorrichtung dafür angepasst ist einen Lichtimpuls zur Ausleuchtung der betreffenden Aufnahme der Digitalkamera auszulösen, der mit der Aufnahmesteuerung der Digitalkamera synchronisiert ist,
- wobei die Auswertevorrichtung dafür angepasst ist, die aneinander anschließenden oder überlappenden Einzelbilder zu einem Gesamtbild des Substrats zusammenzufügen und Abweichungen des Substrats von einem vorgegebenen Substrat oder Übereinstimmungen mit einem vorgegebenen Substrat zu erfassen.

2. Inspektionsvorrichtung nach Anspruch 1, **dadurch gekennzeichnet, dass** der Inspektionskopf (12) einen Tunnel (24) aufweist, der insbesondere Leuchtelemente der Beleuchtungsvorrichtung (14) für die Beleuchtung des Substrats (30) trägt.

3. Inspektionsvorrichtung nach einem der vorhergehenden Ansprüche, **dadurch gekennzeichnet, dass** die zu erfassende Fehlergrösse durch Verstellung der Optik und/oder der Aufnahmeauflösung der Digitalkamera (18) vom Anwender der Inspektionsvorrichtung (10) einstellbar ist und bei gröberer Fehlergrösse die Bildgrösse jedes Einzelbildes vergrösserbar ist oder sein kann.

4. Inspektionsvorrichtung nach einem der vorhergehenden Ansprüche, **dadurch gekennzeichnet, dass** die Beleuchtungsvorrichtung (14) eine Durchlichteinheit aufweist, die unter der Führungsunterlage (32) angebracht ist sich gegebenenfalls mit dieser fortbewegt und mit welcher durchscheinende Substrate (30) inspizierbar sind und dass insbesondere unterhalb der Führungsunterlage (33) eine LED-Bett vorgesehen ist.

5. Inspektionsvorrichtung nach einem der vorhergehenden Ansprüche, **dadurch gekennzeichnet, dass** Substrate (30) als Keramiksubstrate, Keramikfibritsubstrate, Metall, LTCC-Substrate und/oder glasfaserverstärkte Epoxidharzsubstrate ausgebildet sind, die in Mehrschichttechnik (Multilayer) im Siebdruck bedruckbar sind.

6. Inspektionsvorrichtung nach einem der vorhergehenden Ansprüche, **dadurch gekennzeichnet, dass** die Inspektionsvorrichtung (10) Teil einer Erzeugungsanlage für bedruckte Substrate (30) ist, in welcher die teilweise bedruckten Substrate (30) der Inspektionsvorrichtung (10) nach Drucken mindestens einer Sicht zuführbar, dann wieder bedruckbar und dann erneut der Inspektionsvorrichtung (10) zyklisch zuführbar ist, bis sämtliche Schichten inspiziert sind.

7. Inspektionsvorrichtung nach Anspruch 1, **dadurch gekennzeichnet, dass** nach der Inspektion durch die Inspektionsvorrichtung (10) jede Schicht zyklisch in einem Trockenofen oder Brennofen einbrennbar ist.

8. Inspektionsvorrichtung nach einem der vorhergehenden Ansprüche, **dadurch gekennzeichnet, dass** in Anpassung an die verschiedenen Materialien der Schichten die Farbe der Beleuchtungsvorrichtung (14) einstellbar ist, wobei die Beleuchtungsvorrichtung (14) insbesondere eine Vielzahl von LEDs oder Laserdioden aufweist.

9. Inspektionsvorrichtung nach einem der Ansprüche 1 bis 7, **dadurch gekennzeichnet, dass** die Beleuchtungsvorrichtung (14) einen Lichtleiter, insbesondere ein Glasfaserkabel, aufweist und dass zwischen der Beleuchtungsvorrichtung und dem Substrat (30) mindestens eine Linse zur Erhöhung der Leuchtdichte angeordnet ist.

10. Inspektionsvorrichtung nach einem der vorhergehenden Ansprüche, **dadurch gekennzeichnet, dass** die Beleuchtungsvorrichtung (14) eine Taktsteuerung aufweist, mit welcher die einzelnen Leuchtelemente der Beleuchtungsvorrichtung (14) im Impulsbetrieb ansteuerbar sind.

11. Inspektionsvorrichtung nach einem der vorhergehenden Ansprüche, **dadurch gekennzeichnet, dass** eine Digitalkamera zur Erfassung des Bildes des Substrats vorgesehen ist, deren Verschluss offen ist und dass die digitale Belichtung durch die Steuerung der Beleuchtungsvorrichtung erfolgt.

12. Inspektionsvorrichtung nach einem der vorhergehenden Ansprüche, **dadurch gekennzeichnet, dass** die Leuchtelemente der Beleuchtungsvorrichtung (14) in einem sich in einem Winkel von 0 deg. bis 50 deg., insbesondere etwa 20 deg. konisch aufweitenden Tunnel (24) angeordnet sind und insbesondere mindestens teilweise dem Substrat (30) zugewandt sind.

13. Inspektionsvorrichtung nach einem der vorhergehenden Ansprüche, **dadurch gekennzeichnet, dass** an die Digitalkamera (18) ein Framegrabber angeschlossen ist, dessen Ausgang mit einem PC verbunden ist, der die Fehlererkennung vornimmt.

14. Inspektionsvorrichtung nach einem der vorhergehenden Ansprüchen, **dadurch gekennzeichnet, dass** mindestens zwei aufgedruckte Schichten auf dem Substrat (30) vorgesehen sind, die sich insbesondere mindestens teilweise überlappend und nacheinander aufgebracht sind.

15. Inspektionsvorrichtung nach einem der vorhergehenden Ansprüche, **dadurch gekennzeichnet, dass** der Tunnel (24) sich zum Substrat mindestens teilweise aufweitet, insbesondere konisch aufweit und dass an dem Innenumfang des Tunnels (24) eine Vielzahl von Leuchtelementen angebracht sind.

## Claims

1. An inspection device, having
- a guide carrier (32) which can support a substrate which is to be inspected and comprises applied layers, and
- an inspection head (12) which is movable relative to this guide carrier (32) in at least two directions,
- wherein the inspection head (12) comprises
an illumination device (14) and
a detection device (16)
- an evaluation device and
- a movement device (34) configured to move the guide carrier (32) relative to the inspection head (12) and to control this movement,
- wherein the detection device (16) detects electromagnetic radiation reflected from the substrate or penetrated through it and conveys it to an evaluation device, and comprises a digital camera (18) having optics configured to detect a resolution of less than 200, in particular less then 30, micrometers on the substrate (30), and
**characterized in that**
- the inspection device is configured to detect sequential or slightly overlapping individual images during uniform movement of the movement device, and
- wherein the illumination device is configured to trigger a light pulse for illuminating the respective object or target of the digital camera, which is synchronized with the image-taking control of the digital camera,
- wherein the evaluation device is configured to join the sequential or overlapping individual images into one overall image of the substrate and to detect deviations of the substrate from a predetermined substrate or matches with a predetermined substrate.

2. The inspection device according to claim 1, **characterized in that** the inspection head (12) comprises a tunnel (24) which in particular supports illumination elements of the illumination device (14) for the illumination of the substrate (30).

3. The inspection device according to one of the preceding claims, **characterized in that** the error value which is to be detected can be adjusted by the user of the inspection device (10) by adjusting the optics and/or the picture-taking resolution of the digital camera (18) and with a more approximate error value, the image size of each individual image is or can be increased.

4. The inspection device according to one of the preceding claims, **characterized in that** the illumination device (14) comprises a transillumination unit which is disposed below the guide carrier (32), optionally moves with it and via which translucent substrates (30) can be inspected and that in particular below the guide carrier (33) an LED bed is provided.

5. The inspection device according to one of the preceding claims, **characterized in that** substrates (30) are in the form of ceramic substrates, ceramic fibrit substrates, metal, LTCC substrates and/or glass fiber reinforced epoxide resin substrates which can be printed using multilayer screen printing technology.

6. The inspection device according to one of the preceding claims, **characterized in that** the inspection device (10) is part of a production plant for printed-on substrates (30) in which the partially printed-on substrates (30) can be fed to the inspection device (10) after printing at least one layer, can then again be printed-on and then again fed cyclically to the inspection device (10) until all layers are inspected.

7. The inspection device according to one of the preceding claims, **characterized in that** after the inspection by the inspection device (10), each layer can be cyclically introduced into a drying furnace or firing furnace.

8. The inspection device according to one of the preceding claims, **characterized in that** in adaptation to the various materials of the layers, the color of the illumination device (14) can be adjusted, wherein the illumination device (14) in particular has a plurality of LEDs or laser diodes.

9. The inspection device according to one of the claims 1 to 7, **characterized in that** the illumination device (14) has a light guide, in particular a glass fiber cable, and that at least one lense is disposed between the illumination device and the substrate (30) to increase the brightness.

10. The inspection device according to one of the preceding claims, **characterized in that** the illumination device (14) comprises a fixed-cycle control via which the individual illumination elements of the illumination device (14) can be controlled in a pulsed operation.

11. The inspection device according to one of the preceding claims, **characterized in that** a digital camera is provided for detecting the image of the substrate the shutter of which is open and that the digital illumination is effected by the control of the illumination device.

12. The inspection device according to one of the preceding claims, **characterized in that** the illumination elements of the illumination device (14) are disposed in a tunnel (24) which conically widens at an angle of 0° to 50°, in particular about 20°, and in particular at least partially face the substrate (30).

13. The inspection device according to one of the preceding claims, **characterized in that** a frame grabber is connected to the digital camera (18), the output of which is connected to a PC which undertakes the error recognition.

14. The inspection device according to one of the preceding claims, **characterized in that** at least two printed-on layers are provided on the substrate (30) which are in particular applied in an at lest partially overlapping and sequential manner.

15. The inspection device according to one of the preceding claims, **characterized in that** the tunnel (24) widens at least partially toward the substrate, in particular in a conical manner, and that a plurality of illumination elements are mounted on the inner periphery of the tunnel (24).

## Revendications

1. Dispositif d'inspection avec - une base de guidage (32) sur lequel un substrat à inspecter, qui présente 2 couches appliquée, peut être logé et
- une tête d'inspection (12), qui est mobile par rapport à cette base de guidage (32) dans au moins deux directions
- où la tête d'inspection (12) présente un dispositif d'éclairage (14) et un dispositif de saisie (16),
- un mécanisme d'évaluation et
- un mécanisme de mouvement (34), qui est étudié pour déplacer la base de guidage (32) par rapport à la tête d'inspection (12) et de contrôler ce mouvement,
- où le dispositif de saisie (16) enregistre des rayonnements électromagnétiques reflétés du substrat ou passés à travers celui-ci et les transmet vers le mécanisme d'évaluation et présente un appareil photo numérique (18) avec un objectif qui est conçue pour capturer une résolution à partir de moins de 200, de préférence moins de 30 microns au dessus du substrat (30) et
**caractérisé en ce que** le dispositif d'inspection est adapté pour capturer des images individuelles contiguës ou qui se chevauchent légèrement lors de mouvements uniformes du mécanisme de mouvement, et
- où le dispositif d'éclairage est adapté pour déclencher une impulsion de lumière pour éclairer l'enregistrement concerné par l'appareil photo numérique, qui est synchronisé avec le contrôle de l'enrégistrement de l'appareil photo numérique
- où le mécanisme d'évaluation est adapté pour regrouper les trames contiguës ou qui se chevauchent en une vue d'ensemble et enregistrer des déviations du substrat par rapport à un substrat prédéfini ou des concordances avec un substrat donné.

2. Dispositif d'inspection selon la revendication 1, **caractérisé en ce que** la tête d'inspection (12) présenté un tunnel (24), qui porte en particulier des éléments lumineux du dispositif d'éclairage (14) pour l'éclairage du substrat (30).

3. Dispositif d'inspection selon l'une des revendications précédentes, **caractérisé en ce que** la taille de défaut à détecter en ajustant l'optique et/ou la résolution d'image de l'appareil photo numérique (18) est réglable par l'utilisateur du dispositif d'inspection (10) et pour les défaut plus grossiers la taille de chaque image individuelle est agrandie ou peut être agrandie.

4. Dispositif d'inspection selon l'une des revendications précédentes, **caractérisé en ce que** le dispositif d'éclairage (14) dispose d'une unité de translumination, qui est logé sous la base de guidage (32), se déplace éventuellement avec celui-ci et avec lequel, des substrats translucides (30) peuvent être inspectés et qu'en particulier banc de LED est prévu sous la base de guidage (33).

5. Dispositif d'inspection selon l'une des revendications précédentes, **caractérisé en ce que** des substrats (30) sont formés comme substrats en céramique, des substrats de fibrit céramique, en métal, des substrats LTCC et/ou des substrats de résines époxy renforcé de fibre de verre, qui sont imprimables en technique multicouche (multilayer) en sérigraphie.

6. Dispositif d'inspection selon l'une des revendications précédentes, **caractérisé en ce que** le dispositif d'inspection (10) fait partie d'un système de production pour les substrats imprimées (30), dans lequel les substrats partiellement imprimées (30) après avoir l'impression d'au moins un couche sont transportables vers le dispositif d'inspection (10), et ensuite peuvent être à nouveau imprimés, et retransportés vers le dispositif d'inspection (10) de manière cyclique, jusqu'à ce que toutes les couches ont été inspectées.

7. Dispositif d'inspection selon la revendication 1, **caractérisé en ce que** suivant l'inspection par le dispositif d'inspection (10) chaque couche peut être cuite dans un four ou un four à séchage.

8. Dispositif d'inspection selon l'une des revendications précédentes, **caractérisé en ce que** en fonction des différentes matières des couches, la couleur du dispositif d'éclairage (14) est réglable où (14) le dispositif d'éclairage dispose en particulier d'une pluralité de LED ou diodes laser.

9. Dispositif d'inspection selon l'une des revendications 1 à 7, **caractérisé en ce que** le dispositif d'éclairage (14) présente un conducteur optique, en particulier, un câble de fibre optique et qu'au moins une lentille pour augmenter la luminance est disposée entre le dispositif d'éclairage (14) et le substrat (30).

10. Dispositif d'inspection selon l'une des revendications précédentes, **caractérisé en ce que** le dispositif d'éclairage (14) présente une commande cadencée, avec laquelle les éléments lumineux du dispositif d'éclairage (14) sont contrôlables en mode d'impulsion.

11. Dispositif d'inspection selon l'une des revendications précédentes, **caractérisé en ce qu'**un appareil photo numérique est prévu pour la capture de l'image du substrat, dont le dispositif de fermeture est ouvert et que l'exposition à la lumière numérique a lieu à travers le contrôle du dispositif d'éclairage.

12. Dispositif d'inspection selon l'une des revendications précédentes, **caractérisé en ce que** les éléments lumineux du dispositif d'éclairage (14) sont disposés dans un tunnel (24) s'élargissant en forme conique dans un angle de 0 degré jusqu'à 50 degrés, de préférence environ 20 degrés, et sont en particulier au moins partiellement tournés vers le substrat (30).

13. Dispositif d'inspection selon l'une des revendications précédentes, **caractérisé en ce qu'**une carte d'acquisition est connecté à l'appareil photo numérique (18), dont la sortie connecté à un PC, qui effectue la détection d'erreur.

14. Dispositif d'inspection de 14 selon l'une des revendications précédentes, caractérisé qui existe au moins deux couches imprimées sont prévues sur le substrat (30), qui sont appliquées au moins partiellement en chevauchement et successivement.

15. Dispositif d'inspection selon l'une des revendications précédentes, **caractérisées en ce que** le tunnel (24) s'élargit au moins en partie vers le substrat, s'élargit de préférence en forme conique, et qu'une pluralité d'éléments d'éclairage sont attachés à la circonférence interne du tunnel (24).
